# EUROPEAN PATENT APPLICATION

(11) **EP 4 722 932 A1**
(43) Date of publication of application: **08.04.2026**
(21) Application number: 25205787.2
(22) Date of filing: 30.09.2025
(51) Int. Cl.: G06F 13/16, H04B 3/32, H04L 25/49, G06F 13/40, H04B 3/487

(54) **MEMORY CONTROLLER USING A DIGITAL SIGNAL PROCESSOR IN TRANSMITTERS TO MITIGATE NOISE AND DISTORTION IN MEMORY LINKS**

(30) Priority: 02.10.2024 US 202463702617 P; 04.10.2024 US 202463703245 P; 23.09.2025 US 202519337130
(71) Applicant: MEDIATEK INC., Hsinchu City 30078 (TW)
(72) Inventor: KUMAR, Arvind, San Jose (US); KUMASHIKAR, Mahesh K., San Jose (US); ANKIREDDY, Nalamalpu, San Jose (US)
(74) Representative: Haseltine Lake Kempner LLP

(57) **Abstract**

A memory controller in an integrated circuit system includes a transmitter module. The transmitter module receives from a processor a bit stream including a given symbol to be transmitted according to pulse-amplitude-modulation (PAM) with N signal levels on a first lane of multiple lanes. The lanes connect the transmitter module to a memory module in the integrated circuit system. The transmitter module identifies parameters for cancelling crosstalk from other lanes on the first lane. The parameters are identified based on a pending transition in signal levels in each of the other lanes. The transmitter module superposes the parameters of the other lanes on the given symbol to adjust the given symbol on the first lane. A digital-to-analog converter (DAC) on the first lane generates an analog output to the memory module. The analog output represents the adjusted given symbol.

## Description

### TECHNICAL FIELD

Embodiments of the invention relate to memory controllers and memory I/O techniques in an integrated circuit system.

### BACKGROUND OF THE INVENTION

Modern memory controllers support high efficiency and low latency data transfer between a processor and a memory device. A memory controller translates and coordinates high-level memory access requests from a processor into low-level electrical signals that read from or write to the memory. Based on the memory access requests, the memory controller determines which row and column in a memory cell array to access.

A memory controller also schedules memory I/O commands from a processor, such as read, write, activate (row access), precharge (row close), and refresh to the memory based on timing rules. Additionally, the memory controller performs timing management and read/write data buffering to manage differences in data rates or timing between the processor and the memory.

Modern high-speed memory I/O requires memory controllers to handle a large amount of data transfer at high frequencies. The high data rates can cause signal integrity issues. Noise, distortion, crosstalk, and intersymbol interference become significant problems that can corrupt data. A robust transceiver is needed to maintain the signal integrity. The designs of memory controllers continue evolving to support faster, larger, and more power-efficient computing. The demands on memory controllers with respect to timing, power, and reliability continue to grow. Therefore, there is a need for further improvement of memory controller technologies.

### SUMMARY OF THE INVENTION

In one embodiment, a method is performed by a transmitter module in a memory controller in an integrated circuit system. The method comprises the transmitter module receiving, from a processor, a bit stream including a given symbol to be transmitted according to pulse-amplitude-modulation (PAM) with N signal levels on a first lane of a plurality of lanes. The lanes connect the transmitter module to a memory module in the integrated circuit system. The transmitter module identifies parameters for cancelling crosstalk on the first lane from other lanes of the plurality of lanes. The parameters are identified based on a pending transition in signal levels in each of the other lanes. The method further comprises superposing the parameters of the other lanes on the given symbol to adjust the given symbol on the first lane; and generating an analog output to the memory module by a digital-to-analog converter (DAC) on the first lane. The analog output represents the adjusted given symbol.

In another embodiment, a memory controller in an integrated circuit system includes a receiver module to receive incoming data from a memory module in the integrated circuit system, and a transmitter module including a plurality of transmitter circuits to transmit outgoing data to the memory module on a plurality of lanes, respectively. The transmitter module is operative to receive, from a processor, a bit stream including a given symbol to be transmitted according to PAM with N signal levels on a first lane, and identify parameters for cancelling crosstalk on the first lane from other lanes. The parameters are identified based on a pending transition in signal levels in each of the other lanes. The transmitter module is further operative to superpose the parameters of the other lanes on the given symbol to adjust the given symbol on the first lane, and generate an analog output to the memory module by a DAC on the first lane. The analog output represents the adjusted given symbol.Other aspects and features will become apparent to those ordinarily skilled in the art upon review of the following description of specific embodiments in conjunction with the accompanying figures.

### BRIEF DESCRIPTION OF DRAWINGS

The present invention is illustrated by way of example, and not by way of limitation, in the figures of the accompanying drawings in which like references indicate similar elements. It should be noted that different references to "an" or "one" embodiment in this disclosure are not necessarily to the same embodiment, and such references mean at least one. Further, when a particular feature, structure, or characteristic is described in connection with an embodiment, it is submitted that it is within the knowledge of one skilled in the art to effect such feature, structure, or characteristic in connection with other embodiments whether or not explicitly described.
FIG. 1 is a block diagram illustrating an integrated circuit system in which embodiments of the invention may operate.
FIG. 2 is a block diagram illustrating a Tx module in a memory controller according to one embodiment.
FIG. 3 is a block diagram illustrating a digital signal processor (DSP) in a Tx module according to one embodiment.
FIG. 4 is a block diagram illustrating further details of the DSP of FIG. 3 according to one embodiment.
FIG. 5 is an example of a lookup table according to one embodiment.
FIG. 6A is a diagram illustrating nonlinear characteristics of a digital-to-analog converter (DAC) according to one embodiment.
FIG. 6B is a block diagram illustrating a predistortion circuit in a DSP according to one embodiment.
FIG. 7A, FIG. 7B, FIG. 7C, and FIG. 7D illustrate a memory controller connecting to different types of memory modules according to some embodiments.
FIG. 8 is a flow diagram illustrating a method performed by a memory controller according to one embodiment.

### DETAILED DESCRIPTION OF THE INVENTION

In the following description, numerous specific details are set forth. However, it is understood that embodiments of the invention may be practiced without these specific details. In other instances, well-known circuits, structures, and techniques have not been shown in detail in order not to obscure the understanding of this description. It will be appreciated, however, by one skilled in the art, that the invention may be practiced without such specific details. Those of ordinary skill in the art, with the included descriptions, will be able to implement appropriate functionality without undue experimentation.

This disclosure describes transmitter circuits ("Tx circuits") in a memory controller that uses a digital signal processor (DSP) to improve the quality of transmitted signals that are sent to a memory module. In one embodiment, the DSP uses calibrated data to adjust digital signals before the digital signals are transmitted on memory lanes. In another embodiment, the DSP pre-distorts a digital signal at the input of a digital-to-analog converter (DAC) to compensate for the nonlinearity of the DAC. In one embodiment, the memory controller communicates with the memory module using pulse amplitude modulation (PAM) with more than two signal levels. The order of PAM refers to the number of distinct signal levels that represent the symbols transmitted with the PAM. For example, "PAM-N" means that N signal levels are used to represent the symbols transmitted with PAM. A higher-order PAM means a larger N value. Using a higher-order PAM means transmitting more bits per symbol, which increases throughput without needing to increase the symbol rate. For the same bit rate, a higher-order PAM allows for a slower symbol rate, which reduces intersymbol interferences and crosstalks.

However, there are tradeoffs in raising the order of the PAM. As the number of signal levels increases, the amplitude difference between each level decreases, leading to a smaller eye opening. The signal-to-noise ratio (SNR) requirement rises significantly with higher-order PAM due to the reduced eye opening. To improve the SNR of a high-order PAM signal transmitted from a memory controller, the memory controller performs digital signal processing to enhance signal quality before a signal is transmitted. In the following description, specific orders of PAM are mentioned, e.g., PAM-4, PAM-8, PAM-16, etc. It is understood that the disclosed memory controller is not limited to the specific PAM mentioned herein.

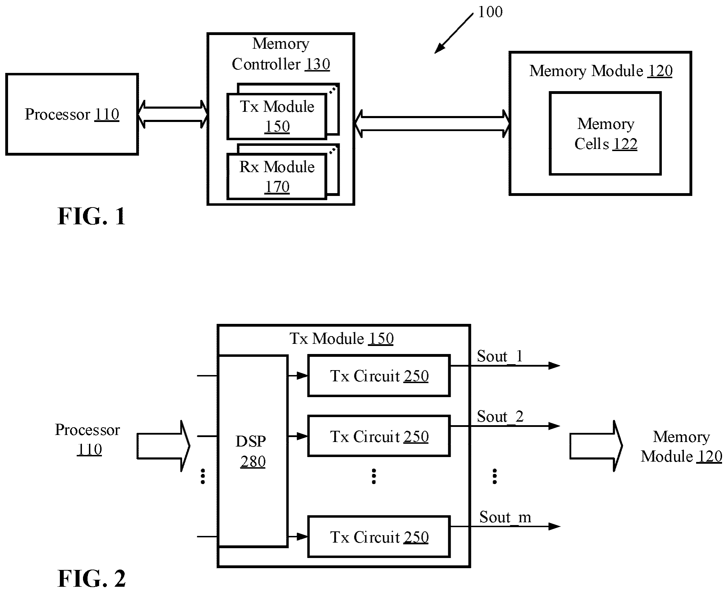

FIG. 1 is a block diagram illustrating an integrated circuit system 100 ("system 100") in which embodiments of the invention may operate. The system 100 includes a processor 110 coupled to a memory controller 130. The memory controller 130 reads from and writes to a memory module 120 when directed by the processor 110. The memory module 120 includes arrays of memory cells 122 for data storage. In one embodiment, the memory controller 130 may be co-located with the processor 110 on one chip, and the memory module 120 may be located outside of the chip. In another embodiment, the memory controller 130, the processor 110, and the memory module 120 may all co-located on the same chip.

Although one processor 110 is shown in FIG. 1, it is understood that the system 100 may include multiple processors and each processor may include one or more processing cores or computation units. Non-limiting examples of the processor 110 include, a central processing unit (CPU), a graphics processing unit (GPU), a digital signal processor (DSP), a neural processing unit (NPU), and any processing units that uses a memory controller to access the memory module 120.

The memory controller 130 includes one or more transmitter (Tx) modules 150 and one or more receiver (Rx) modules 170, among other components. The Tx module 150 and the Rx module 170 communicate with the memory module 120 to write to and read from, respectively, the memory cells 122 of the memory module 120. In a memory I/O interface that supports a high-count of memory lanes (e.g., hundreds of lanes or more), memory lanes may be bundled and routed in multiple groups. Each of the Tx modules 150 and the Rx modules 170 is responsible for communication on a group of the memory lanes. The memory lanes in the same group are physically close to one another and, therefore, generate more crosstalk on one another than the memory lanes in different groups. In the following description, the crosstalk cancellation technique targets the memory lanes in the same group. It is understood that the same technique is applicable to different groups of memory lanes with a higher hardware cost.

FIG. 2 is a block diagram illustrating further details of the Tx module 150 according to one embodiment. The Tx module 150 includes a DSP 280 to perform crosstalk cancellation before signals are transmitted out of the memory controller 130. The DSP 280 is coupled to multiple (e.g., *m*) Tx circuits 250, and each Tx circuit 250 transmits a signal (*Sout*) on a corresponding one of the *m* memory lanes ("lanes"). The transmitted signal may carry any information such as data, command, address, timing, etc. Each Tx circuit 250 transmits a signal at one of the PAM signal levels in each unit time interval. Each signal level is mapped to a bit group representing a symbol. In one embodiment, each signal level may be mapped to a Grey-coded bit group. For PAM-4, there are 4 signal levels and each symbol contains 2 bits; for PAM-8, there are 8 signal levels and each symbol contains 3 bits; for PAM-16, there are 16 signal levels and each symbol contains 4 bits, and so on.

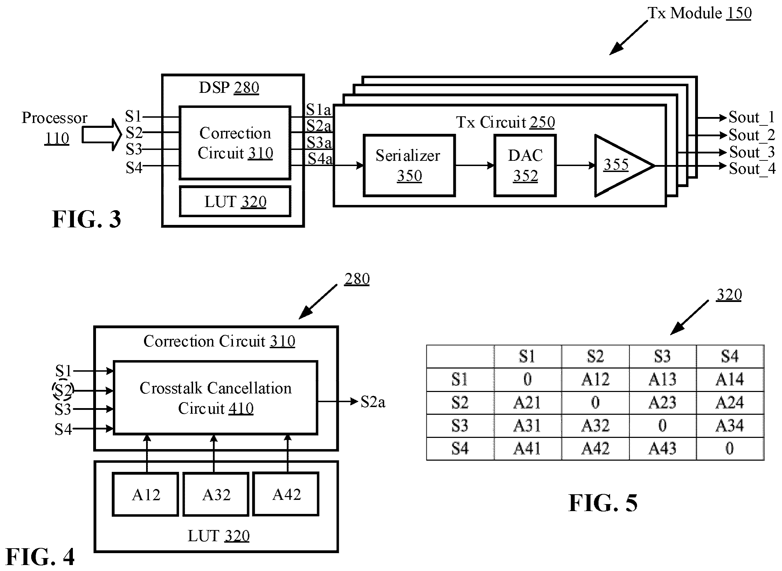

FIG. 3 is a block diagram illustrating the Tx module 150 in more detail according to one embodiment. For simplicity of illustration, the number of memory lanes supported by the Tx module 150 is four (*m* = 4) as an example. It is understood that the number of memory lanes can be any positive integer not limited to four. The Tx module 150 receives four signals (S1, S2, S3, S4) from the processor 110. The DSP 280 performs crosstalk cancellation on each of the signals to generate adjusted signals (S1a, S2a, S3a, S4a), respectively, and sends the adjusted signals to respective Tx circuits 250 for transmission on respective lanes. The DSP 280 includes a correction circuit 310 and a data structure such as one or more lookup tables (e.g., a LUT 320). Operations of the DSP 280 will be described later with reference to FIG. 4 and FIG. 5.

In one embodiment, the Tx circuit 250 includes, among other circuit components, a serializer 350, a digital-to-analog converter (DAC) 352, and an output driver 355. The serializer 350 converts parallel data bits into a serial bitstream with increased data rate, and creates bit groups representing symbols according to a modulation scheme such as PAM with N signal levels, where N is a positive integer. The DAC 352 converts serialized digital symbols into corresponding analog voltage levels, and the output driver 355 drives the electrical current representing the analog voltage levels onto a lane. In this example, the output signals from the Tx circuits are shown as Sout_1, Sout_2, Sout_3, and Sout_4.

FIG. 4 is a block diagram illustrating further details of the DSP 280 according to one embodiment. In one embodiment, the correction circuit 310 in the DSP 280 includes a crosstalk cancellation circuit 410 to mitigate or cancel the crosstalk on each of the signals to be transmitted. In the non-limiting example of four signals (S1, S2, S3, S4) on four lanes, respectively, the crosstalk cancellation circuit 410 determines and performs a respective correction action for each of the four signals. For clarity of the description, the lane affected by the crosstalk is called a victim lane and the lane causing the crosstalk is called an aggressor lane. Each lane in this example is an aggressor lane carrying an aggressor signal that causes crosstalk on the other three signals on the other three lanes. Each lane is also a victim lane carrying a victim signal affected by the other three signals on the other three lanes. The correction action may include adjusting the timing and amplitude of each victim signal. The amount of adjustment to a given symbol on a victim lane is dependent on each aggressor signal's pending transition of signal levels. For example, an aggressor signal's pending transition is the difference between the previous symbol that has been transmitted on the aggressor lane and the pending symbol to be transmitted on the aggressor lane. The pending symbol may be transmitted substantially concurrently with the given symbol on the victim lane.

In one embodiment, the correction actions for each victim signal with respect to each aggressor signal are determined in a training phase. During a training pass of the training phase, the Tx circuit 250 on an aggressor lane ("Tx1") transmits a signal (e.g., S1) with a known pattern of repeated transitions between two signal levels of PAM (e.g., toggle between 0000 and 1111 in each unit time interval of PAM-4 transmission), and the Tx circuit 250 on a victim lane ("Tx2") transmits a signal (e.g., S2) at random signal levels of PAM-4. At the receiver side on the victim lane, an analyzer creates an eye diagram of the received victim signal and measures the reductions in the width and the height of each eye opening, when compared with S1 not being present. The analyzer further calculates adjustment parameters for the DSP 280 (FIG. 2 and FIG. 3) to adjust the timing and the amplitude of the victim signal to thereby restore the eye openings of the victim signal. The training continues for the victim signal S2 with respect to different magnitudes of signal transitions (e.g., change in signal levels) of S1. For PAM-N (i.e., PAM with N signal levels), Tx1 may transmit N different magnitudes of signal transitions of S1 in N different training passes, respectively, while Tx2 transmits S2 at random signal levels. The results of the N training passes are N adjustment parameter sets for adjusting the timing and the amplitude of S2 when S1 is present. The training repeats for each of the aggressor lanes. The resulting adjustment parameters are stored in a LUT 320 at the Tx module 150 for use by the DSP 280. The LUT 320 may be stored in memory registers or other types of fast memory.

FIG. 5 is an example of the LUT 320 according to one embodiment. In one embodiment, the LUT 320 may be organized as a two-dimensional data structure. In the non-limiting example of four signals (S1, S2, S3, S4), the first column of the LUT 320 includes adjustment data A21, A31, and A41 for cancelling the crosstalk on S1 caused by S2, S3, and S4, respectively, the second column includes adjustment data A12, A32, and A42 for cancelling the crosstalk on S2 caused by S1, S3, and S4, respectively, and so on. The example of FIG. 5 shows that the crosstalk cancellation for the victim signal S2 uses adjustment data A12, A32, and A42 to generate the adjusted digital signal S2a. In one embodiment, each adjustment data includes adjustment parameters indexed by a distinct amount of signal transition (e.g., a distinct amount of change in signal levels) of an aggressor signal. In the example of PAM-N, A32 includes an array of N adjustment parameter sets, with each adjustment parameter set corresponding to a distinct amount of signal transition of S3. Thus, for each victim signal transmitted according to PAM-N, the lookup table contains (*m*-1) x N adjustment parameter sets for the victim lane to cancel crosstalk from (*m*-1) other lanes, where *m* is the total number of cross-interfering signals.

In one embodiment, each adjustment parameter set includes a timing adjustment parameter for advancing or delaying a victim symbol, and an amplitude adjustment parameter for adjusting digital values representing the victim symbol. The amplitude adjustment parameter may include an offset adjustment and/or a gain adjustment. The DSP 280 may further process the adjusted victim symbol (e.g., digital filtering, digital pulse shaping, oversampling, etc.) before sending an adjusted digital signal to the DAC 352 and the driver 355 to generate an analog output signal.

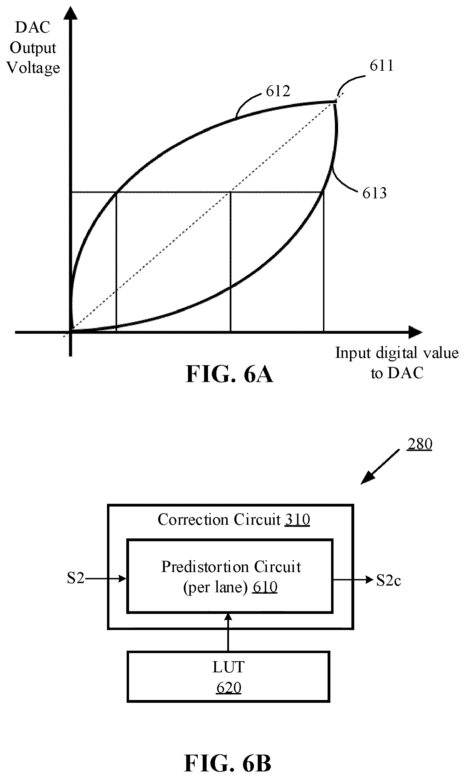

In addition or alternative to crosstalk cancellation, the DSP 280 may perform predistortion operations to compensate for the nonlinearity of the DAC 352. FIG. 6A is a diagram illustrating nonlinear characteristics of the DAC 352 according to one embodiment. The transfer curve of an ideal DAC is a straight line 611 and has uniform step sizes. Due to the integral nonlinearities (INL) and differential nonlinearities (DNL), the transfer curve of the DAC 352 may be a curve 612 or 613. Initialization and training can handle and train out some INL, but not completely. To compensate for the nonlinearity of the DAC 352, an inverse function of the transfer function of the DAC 352 is calculated and applied to the input signal of the DAC 352. The inverse function is referred to as the digital predistortion (DPD) function. In one embodiment, the DSP 280 performs DPD operations on signals to be transmitted before they reach the respective DACs 352. The DPD operation is performed per lane as different DACs may have different transfer functions. When the nonlinear DAC 352 processes the pre-distorted signal, the predistortion cancels out (or mostly cancels out) the effects of the nonlinearities of the DAC 352.

FIG. 6B is a block diagram illustrating a predistortion circuit 610 in the DSP 280 according to one embodiment. In one embodiment, the correction circuit 310 includes the predistortion circuit 610 per lane. The predistortion circuit 610 applies a predistortion value (e.g., a digital value) to a digital signal before the digital signal is converted by the DAC 352 for transmission, so that the combined effect of predistortion and nonlinearity of the DAC 352 becomes substantially linear. For example, the predistortion circuit 610 may obtain the predistortion value from a LUT 620 to pre-distort a signal S2 and generate S2c as input to the DAC 352. In one embodiment, the LUT 620 stores a set of predistortion values for the DAC 352 on each lane. Each set of predistortion values includes predistortion values for predistorting a range of digital signal levels at the DAC input .

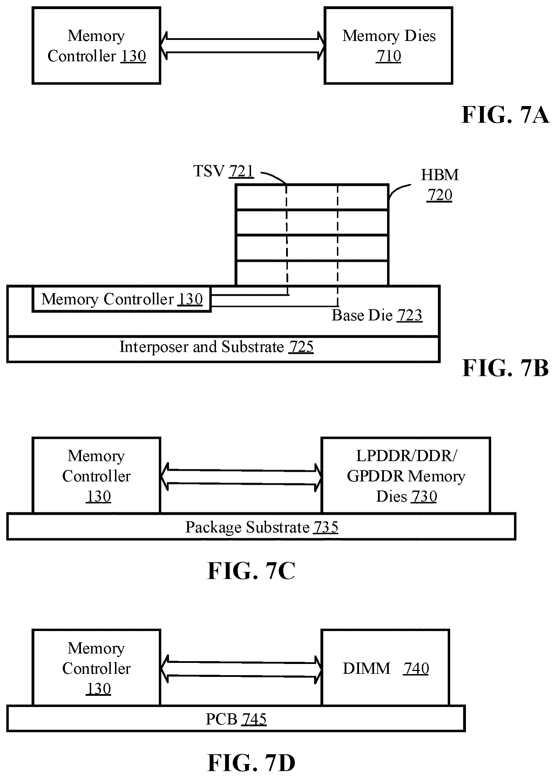

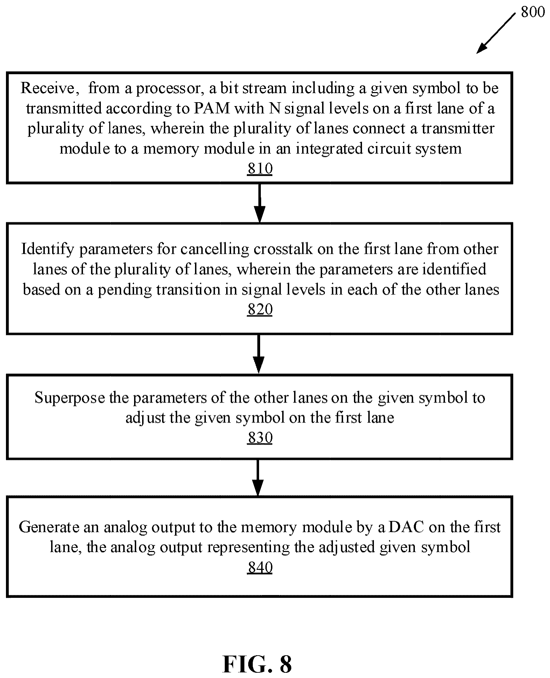

FIG. 7A-FIG. 7D illustrate the memory controller 130 connecting to different types of memory modules according to some embodiments. FIG. 7A shows that the memory controller 130 is connected to one or more memory dies 710. The memory dies 710 can be fabricated by any known fabrication technologies and can communicate with the memory controller 130 according to any known memory I/O protocols. For example, the memory dies 710 may be a dynamic random access memory (DRAM), synchronous DRAM (SDRAM), ferroelectric RAM (FeRAM), phase-change memory (PCM), etc. In FIG. 7B, the memory controller 130 communicates with a high bandwidth memory (HBM) module 720 that includes memory dies arranged in a vertical stack and accessible via TSVs 721. The memory controller 130 and the HBM modules 720 may be co-located on a base die 723, which is on top an interposer and substrate 725. It is noted that stacked memory technologies are not limited to the HBM module 720. The aforementioned memory controller 130 can operate with memory stacks formed by other memory technologies, such as low-power double data rate (LPDDR) memory stacks. In one embodiment, LPDDR memory dies may be wire-bonded into a vertical stack, with the bottom LPDDR die wire-bonded to a package substrate. Alternatively, the LPDDR memory stack may be encapsulated in a package. FIG. 7C shows the memory controller 130 in communication with DDR-based memory dies 730 such as DDR4, DDR5, DDR6, LPDDR, graphics DDR (GDDR) memory dies. The memory controller 130 and the DDR-based memory dies 730 may be co-located on the same package substrate 735. Alternatively, the DDR-based memory dies 730 may be in a separate package from the memory controller 130. FIG. 7D shows the memory controller 130 in communication with a DIMM 740 containing multiple memory dies. The memory controller 130 and the DIMM 740 may be co-located on the same printed circuit board (PCB) 745. The memory controller 130 in FIG. 7A-FIG. 7D performs the aforementioned oversampling operations. More specifically, the memory controller 130 in FIG. 7A-FIG. 7D performs the method 800 (FIG. 8).

FIG. 8 is a flow diagram illustrating a method 800 performed by a Tx module in a memory controller in an integrated circuit system according to one embodiment. Referring also to FIG. 2, an example of the Tx module may be the Tx module 150. The method 800 starts at step 810 when the Tx module receives, from a processor, a bit stream including a given symbol to be transmitted according to PAM with N signal levels on a first lane of a plurality of lanes. The lanes connect the transmitter module to a memory module in the integrated circuit system. The Tx module (more specifically, a DSP in the Tx module such as the DSP 280) identifies parameters for cancelling crosstalk on the first lane from the other lanes of the plurality of lanes. The parameters are identified based on a pending transition in signal levels in each of the other lanes. The DSP superposes the parameters of the other lanes on the given symbol to adjust the given symbol on the first lane. The Tx module then generates an analog output to the memory module by a DAC on the first lane. The analog output represents the adjusted given symbol.

In one embodiment, the parameters of each of the other lanes include a timing adjustment parameter and an amplitude adjustment parameter. In one embodiment, applying the parameters may include advancing or delaying the given symbol according to a timing adjustment parameter of each of the other lanes on the given symbol. In one embodiment, superposing the parameters may include adjusting digital values representing the given symbol according to the amplitude adjustment parameter of each of the other lanes on the given symbol. In one embodiment, the pending transition in signal levels is between a previous symbol that has been transmitted and a pending symbol to be transmitted on each of the other lanes.

In one embodiment, the Tx module receives respective symbols to be transmitted on the plurality of lanes, identifies respective pending transitions in signal levels in the plurality of lanes, adjusts the respective symbols on the plurality of lanes according to a lookup table containing crosstalk cancellation parameters, and converting the adjusted respective symbols to analog outputs to the memory module by respective DACs on the plurality of lanes. The analog outputs represent the adjusted respective symbols. In one embodiment, for signals transmitted according to PAM with N signal levels on each lane, the lookup table contains (m-1) x N sets of parameters for the lane to cancel crosstalk from (m-1) other lanes.

In one embodiment, the DSP in the Tx module identifies a predistortion value to compensate for nonlinearity of the DAC on the first lane from a second lookup table, and adjusts an input to the DAC by the predistortion value to generate the analog output representing the adjusted given symbol. In one embodiment, the predistortion value is dependent on a signal value of the given symbol. In one embodiment, the DSP superposes the parameters of the other lanes and the predistortion value on the given symbol to adjust the given symbol on the first lane.

The operations of the flow diagram of FIG. 8 have been described with reference to the exemplary embodiments of FIG. 1-5 and 7. However, it should be understood that the operations of the flow diagram of FIG. 8 can be performed by embodiments of the invention other than the embodiments of FIG. 1-5 and 7, and these embodiments can perform operations different than those discussed with reference to the flow diagram. While the flow diagram of FIG. 8 shows a particular order of operations performed by certain embodiments of the invention, it should be understood that such order is exemplary (e.g., alternative embodiments may perform the operations in a different order, combine certain operations, overlap certain operations, etc.).

Various functional components or blocks have been described herein. As will be appreciated by persons skilled in the art, the functional blocks will preferably be implemented through circuits (either dedicated circuits or general-purpose circuits, which operate under the control of one or more processors and coded instructions), which will typically comprise transistors that are configured in such a way as to control the operation of the circuitry in accordance with the functions and operations described herein.

While the invention has been described in terms of several embodiments, those skilled in the art will recognize that the invention is not limited to the embodiments described, and can be practiced with modification and alteration within the spirit and scope of the appended claims. The description is thus to be regarded as illustrative instead of limiting.

Various embodiments are set out in the following numbered clauses:
Clause 1. A method of a transmitter module in a memory controller in a integrated circuit system, comprising receiving, from a processor, a bit stream including a given symbol to be transmitted according to pulse-amplitude-modulation (PAM) with N signal levels on a first lane of a plurality of lanes, wherein the plurality of lanes connect the transmitter module to a memory module in the integrated circuit system identifying parameters for cancelling crosstalk on the first lane from other lanes of the plurality of lanes, wherein the parameters are identified based on a pending transition in signal levels in each of the other lanes superposing the parameters of the other lanes on the given symbol to adjust the given symbol on the first lane; and generating an analog output to the memory module by a digital-to-analog converter (DAC) on the first lane, the analog output representing the adjusted given symbol.
Clause 2. The method of clause 1, wherein the parameters of each of the other lanes include a timing adjustment parameter and an amplitude adjustment parameter.
Clause 3. The method of clause 1, wherein applying the parameters further comprises: advancing or delaying the given symbol according to a timing adjustment parameter of each of the other lanes on the given symbol.
Clause 4. The method of clause 1, wherein superposing the parameters further comprises: adjusting digital values representing the given symbol according to the amplitude adjustment parameter of each of the other lanes on the given symbol.
Clause 5. The method of clause 1, wherein the pending transition in signal levels is between a previous symbol that has been transmitted and a pending symbol to be transmitted on each of the other lanes.
Clause 6. The method of clause 1, further comprising: receiving, at the transmitter module, respective symbols to be transmitted on the plurality of lanes; identifying respective pending transitions in signal levels in the plurality of lanes; adjusting the respective symbols on the plurality of lanes according to a lookup table containing crosstalk cancellation parameters; and converting the adjusted respective symbols to analog outputs to the memory module by respective DACs on the plurality of lanes, the analog outputs representing the adjusted respective symbols.
Clause 7. The method of clause 6, wherein, for signals transmitted according to PAM with N signal levels on each lane, the lookup table contains (m-1) x N sets of parameters for the lane to cancel crosstalk from (m-1) other lanes.
Clause 8. The method of clause 1, further comprising: identifying a predistortion value to compensate for nonlinearity of the DAC on the first lane from a second lookup table; and adjusting an input to the DAC by the predistortion value to generate the analog output representing the adjusted given symbol.
Clause 9. The method of clause 8, wherein the predistortion value is dependent on a signal value of the given symbol.
Clause 10. The method of clause 8, further comprising: superposing the parameters of the other lanes and the predistortion value on the given symbol to adjust the given symbol on the first lane.
Clause 11. A memory controller in an integrated circuit system, comprising: a receiver module to receive incoming data from a memory module in the integrated circuit system; and a transmitter module including a plurality of transmitter circuits to transmit outgoing data to the memory module on a plurality of lanes, respectively, wherein the transmitter module is operative to: receive, from a processor, a bit stream including a given symbol to be transmitted according to pulse-amplitude-modulation (PAM) with N signal levels on a first lane of a plurality of lanes; identify parameters for cancelling crosstalk on the first lane from other lanes of the plurality of lanes, wherein the parameters are identified based on a pending transition in signal levels in each of the other lanes; superpose the parameters of the other lanes on the given symbol to adjust the given symbol on the first lane; and generate an analog output to the memory module by a digital-to-analog converter (DAC) on the first lane, the analog output representing the adjusted given symbol.
Clause 12. The memory controller of clause 11, wherein the parameters of each of the other lanes include a timing adjustment parameter and an amplitude adjustment parameter.
Clause 13. The memory controller of clause 11, wherein, when applying the parameters, the transmitter module is further operative to: advance or delay the given symbol according to a timing adjustment parameter of each of the other lanes on the given symbol.
Clause 14. The memory controller of clause 11, wherein, when superposing the parameters, the transmitter module is further operative to:
   adjust digital values representing the given symbol according to the amplitude adjustment parameter of each of the other lanes on the given symbol.
Clause 15. The memory controller of clause 11, wherein the pending transition in signal levels is between a previous symbol that has been transmitted and a pending symbol to be transmitted on each of the other lanes.
Clause 16. The memory controller of clause 11, wherein the transmitter module is further operative to: receive respective symbols to be transmitted on the plurality of lanes; identify respective pending transitions in signal levels in the plurality of lanes; adjust the respective symbols on the plurality of lanes according to a lookup table containing crosstalk cancellation parameters; and convert the adjusted respective symbols to analog outputs to the memory module by respective DACs on the plurality of lanes, the analog outputs representing the adjusted respective symbols.
Clause 17. The memory controller of clause 16, wherein, for signals transmitted according to PAM with N signal levels on each lane, the lookup table contains (m-1) x N sets of parameters for the lane to cancel crosstalk from (m-1) other lanes.
Clause 18. The memory controller of clause 11, wherein the transmitter module is further operative to: identify a predistortion value to compensate for nonlinearity of the DAC on the first lane from a second lookup table; and adjust an input to the DAC by the predistortion value to generate the analog output representing the adjusted given symbol.
Clause 19. The memory controller of clause 18, wherein the predistortion value is dependent on a signal value of the given symbol.
Clause 20. The memory controller of clause 18, wherein the transmitter module is further operative to: superpose the parameters of the other lanes and the predistortion value on the given symbol to adjust the given symbol on the first lane.

## Claims

1. A method of a transmitter module in a memory controller (130) in an integrated circuit system (100), comprising:
receiving (810), from a processor (110), a bit stream including a given symbol to be transmitted according to pulse-amplitude-modulation, PAM, with N signal levels on a first lane of a plurality of lanes, wherein the plurality of lanes connect the transmitter module to a memory module (120) in the integrated circuit system (100);
identifying (820) parameters for cancelling crosstalk on the first lane from other lanes of the plurality of lanes, wherein the parameters are identified based on a pending transition in signal levels in each of the other lanes;
superposing (830) the parameters of the other lanes on the given symbol to adjust the given symbol on the first lane; and
generating (840) an analog output to the memory module (120) by a digital-to-analog converter, DAC, on the first lane, the analog output representing the adjusted given symbol.

2. The method of claim 1, wherein applying the parameters further comprises:
advancing or delaying the given symbol according to a timing adjustment parameter of each of the other lanes on the given symbol.

3. The method of claim1 or claim 2, wherein superposing the parameters further comprises:
adjusting digital values representing the given symbol according to the amplitude adjustment parameter of each of the other lanes on the given symbol.

4. The method of claim 1, further comprising:
receiving, at the transmitter module, respective symbols to be transmitted on the plurality of lanes;
identifying respective pending transitions in signal levels in the plurality of lanes;
adjusting the respective symbols on the plurality of lanes according to a lookup table containing crosstalk cancellation parameters; and
converting the adjusted respective symbols to analog outputs to the memory module (120) by respective DACs on the plurality of lanes, the analog outputs representing the adjusted respective symbols.

5. The method of claim 4, wherein, for signals transmitted according to PAM with N signal levels on each lane, the lookup table contains (m-1) x N sets of parameters for the lane to cancel crosstalk from (m-1) other lanes.

6. The method of claim 1, further comprising:
identifying a predistortion value to compensate for nonlinearity of the DAC on the first lane from a second lookup table; and
adjusting an input to the DAC by the predistortion value to generate the analog output representing the adjusted given symbol.

7. The method of claim 6, further comprising:
superposing the parameters of the other lanes and the predistortion value on the given symbol to adjust the given symbol on the first lane.

8. A memory controller (130) in an integrated circuit system (100), comprising:
a receiver module to receive incoming data from a memory module (120) in the integrated circuit system (100); and
a transmitter module including a plurality of transmitter circuits to transmit outgoing data to the memory module (120) on a plurality of lanes, respectively, wherein the transmitter module is operative to:
receive, from a processor (110), a bit stream including a given symbol to be transmitted according to pulse-amplitude-modulation, PAM, with N signal levels on a first lane of a plurality of lanes;
identify parameters for cancelling crosstalk on the first lane from other lanes of the plurality of lanes, wherein the parameters are identified based on a pending transition in signal levels in each of the other lanes;
superpose the parameters of the other lanes on the given symbol to adjust the given symbol on the first lane; and
generate an analog output to the memory module (120) by a digital-to-analog converter, DAC, on the first lane, the analog output representing the adjusted given symbol.

9. The memory controller (130) of claim 8, wherein, when applying the parameters, the transmitter module is further operative to:
advance or delay the given symbol according to a timing adjustment parameter of each of the other lanes on the given symbol.

10. The memory controller (130) of claim 8 or claim 9 , wherein, when superposing the parameters, the transmitter module is further operative to:
adjust digital values representing the given symbol according to the amplitude adjustment parameter of each of the other lanes on the given symbol.

11. The memory controller (130) of claim 8, wherein the pending transition in signal levels is between a previous symbol that has been transmitted and a pending symbol to be transmitted on each of the other lanes.

12. The memory controller of claim 8, wherein the transmitter module is further operative to:
receive respective symbols to be transmitted on the plurality of lanes;
identify respective pending transitions in signal levels in the plurality of lanes;
adjust the respective symbols on the plurality of lanes according to a lookup table containing crosstalk cancellation parameters; and
convert the adjusted respective symbols to analog outputs to the memory module (120) by respective DACs on the plurality of lanes, the analog outputs representing the adjusted respective symbols.

13. The memory controller of claim 12, wherein, for signals transmitted according to PAM with N signal levels on each lane, the lookup table contains (m-1) x N sets of parameters for the lane to cancel crosstalk from (m-1) other lanes.

14. The memory controller of claim 8, wherein the transmitter module is further operative to:
identify a predistortion value to compensate for nonlinearity of the DAC on the first lane from a second lookup table; and
adjust an input to the DAC by the predistortion value to generate the analog output representing the adjusted given symbol.

15. The memory controller of claim 14, wherein the transmitter module is further operative to:
superpose the parameters of the other lanes and the predistortion value on the given symbol to adjust the given symbol on the first lane.
